**Europäisches Patentamt**

**European Patent Office**

**Office européen des brevets**

(19)

(11) Veröffentlichungsnummer: **0 019 721**
**B1**

(12)
# EUROPÄISCHE PATENTSCHRIFT

(45) Veröffentlichungstag der Patentschrift:
12.10.83

(51) Int. Cl.³: **G 03 B 41/00**

(21) Anmeldenummer: **80102239.3**

(22) Anmeldetag: **25.04.80**

(54) **Optische Projektionseinrichtung zum Ausrichten eines Projektionsbildes auf einer Oberfläche.**

(30) Priorität: **30.05.79 US 43924**

(43) Veröffentlichungstag der Anmeldung:
**10.12.80 Patentblatt 80/25**

(45) Bekanntmachung des Hinweises auf die Patenterteilung:
**12.10.83 Patentblatt 83/41**

(84) Benannte Vertragsstaaten:
**DE FR GB**

(56) Entgegenhaltungen:
**DE-A-2 615 084**
**DE-A-2 718 711**
**DE-A-2 802 286**
**FR-A-2 274 073**
**FR-A-2 389 928**
**US-A-4 007 988**

(73) Patentinhaber: **International Business Machines
Corporation, Old Orchard Road, Armonk, N.Y. 10504 (US)**

(72) Erfinder: **Wilczynski, Janusz Stanislaw, 736 Kitchewan
Road, Ossining New York 10562 (US)**

(74) Vertreter: **Rudack, Günter O., Dipl.-Ing., c/o
International Business Machines Corporation Zurich
Patent Operations Säumerstrasse 4,
CH-8803 Rüschlikon (CH)**

Optische Projektionseinrichtung zum Ausrichten eines Projektionsbildes auf einer Oberfläche

Die vorliegende Erfindung bezieht sich auf eine optische Projektionseinrichtung zum Ausrichten eines Projektionsbildes auf einer Oberfläche, in der sich wenigstens eine Ausrichtmarke befindet. Diese Einrichtung ist für die Durchführung lithographischer Verfahren, besonders bei der Herstellung elektronischer, integrierter Schaltungen, mittels Dunkelfeldbeleuchtung verwendbar.

Die Verwendung von optischen Apparaten zur Projektion von Schaltungsmustern auf Halbleiterplatten, die mit Photolack beschichtet sind, und die Weiterverarbeitung solcher belichteter Platten zur Herstellung entsprechender Schaltungen ist bekannt. In diesen Apparaten werden verschiedene Hilfsmittel für das Ausrichten einer Maske mit Schaltungsmuster auf eine Halbleiterplatte eingesetzt. Beispielsweise beobachtet das Bedienungspersonal die Lage einer projizierten Ausrichtmarke, z.B. Passkreuz, bezüglich entsprechender Ausrichthilfen auf der Halbleiterplatte und justiert diese Lage durch Verschieben eines Ausrichttisches im Handbetrieb. Dadurch werden die Maske mit dem Schaltungsmuster und die Halbleiterplatte korrekt aufeinander ausgerichtet. Dieses Verfahren ist verhältnismässig langsam und unterliegt menschlichen Fehlern.

In gewissen handbetriebenen Apparaten werden kumulierte Ausrichtfehler wegen mechanischer Abtrift im Apparat selber nicht richtig korrigiert. Ausserdem treten Ausrichtdifferenzen auf, wenn die Halbleiterplatte anfänglich bei der Herstellung in einer Maschine ausgerichtet und belichtet wurde, dann aber im Verlauf weiterer Herstellungsschritte in einer anderen Maschine wieder ausgerichtet und belichtet wird.

Schrittweise und mit Wiederholung arbeitende optische Projektionsgeräte bekannter Art benötigen z.B. anfängliches Ausrichten einer Platte und der entsprechenden Maske im Handbetrieb. Danach wird die Platte schrittweise in die nachfolgende Belichtungspositionen verschoben. Es werden aber Halbleiterplatte und Maske nicht bei jedem Schritt neu ausgerichtet, da es bisher kaum möglich war, in geeigneter Weise und automatisch den durch einen Schritt verursachten Ausrichtfehler festzustellen und eine entsprechende Korrektur vorzunehmen.

In der Mikroskopie sind bereits verschiedene Verfahren mit Dunkelfeldbeleuchtung zur Beobachtung kleinster Objekte angewendet worden. Solche sind beispielsweise in den US-Patenten No. 3 752 560 und 1 943 509 beschrieben. Zusätzlich sind Ausrichtanordnungen mit Dunkelfeldbeleuchtung in den Veröffentlichungen der IBM TDB Vol. 17, No. 11, Seite 3264 (April 1975) unter dem Titel «Dark Field Illumination Device» und TDB Vol. 18, No. 2, Seite 414 (Juli 1975) unter dem Titel «Scattered Light Feedback Detector for Automatic Wafer Alignment» beschrieben. Praktische und wirksame Einrichtungen zum automatischen Ausrichten unter Verwendung von Dunkelfeldbeleuchtung gibt es bisher noch nicht.

Aus der DE-A-2 615 084 ist eine optische Projektionseinrichtung zum Ausrichten eines Projektionsbildes auf einer Oberfläche, in der sich wenigstens eine Ausrichtmarke befindet, bekannt. Bei dieser bekannten Einrichtung sind eine Strahlungsquelle, eine den Strahlengang unterbrechende jedoch für einen zum Ausrichten genügenden Strahlenanteil durchlässige Maske, eine Blende mit wenigstens einem Strahlendurchlass für den zum Ausrichten dienenden Strahlenanteil und ein den Strahlenanteil fokussierendes und auf der genannten Oberfläche abbildendes Objektiv vorgesehen, das die von der Oberfläche reflektierten Strahlen in Richtung der Blende, die an der Ausrichtvorrichtung abgelenkten Strahlen jedoch in davon abweichender Richtung fokussiert. In dieser bekannten Einrichtung wird eine physikalische Strahlenteilung von Projektions- und Beobachtungsstrahlengang durch einen teildurchlässigen Spiegel erreicht, mit dem Nachteil, dass ein relativ breites Projektionsstrahlenbündel erforderlich ist. Mit der Erfindung wird die Vermeidung dieses Nachteils bezweckt, indem, – eine entsprechend intensive Strahlungsquelle vorausgesetzt – ein relativ kleines Projektionsstrahlenbündel gewählt werden kann und daher für die reflektierte Strahlung eine grosse Apertur des Objektivs bzw. des Spiegels zur Verfügung steht.

Die von diesem Stand der Technik ausgehende und im Oberbegriff des Anspruchs 1 definierte Erfindung ist dadurch gekennzeichnet, dass ein teildurchlässiger Spiegel als geometrischer Strahlungsteiler ausgebildet ist, der den zum Ausrichten vorgesehenen Strahlungsanteil zu der auszurichtenden Oberfläche durchlässt und den an der oder den Ausrichtmarken reflektierten Strahlenanteil zum Strahlungsdetektor ablenkt.

Die Erfindung wird nachstehend in Ausführungsbeispielen und anhand zugehöriger Zeichnungen erläutert. In den Zeichnungen zeigen:

Fig. 1 die schematische Darstellung einer ersten Ausführung der optischen Projektionseinrichtung,

Fig. 2 eine nicht-massstäbliche Draufsicht auf eine Maske mit Schlitzen, die dem Ausrichten nach x-, y- und Winkelkoordinaten dienlich sind,

Fig. 3 eine Draufsicht auf ein blendenähnliches Element, wie es in Fig. 1 verwendet ist,

Fig. 4 eine nicht-massstäbliche Draufsicht auf rechtwinklige Ausrichthilfen in der Oberfläche einer Halbleiterplatte,

Fig. 5 eine Schnittansicht der Ausrichthilfen von Fig. 4 entlang einer Linie 2–2,

Fig. 6 eine schematische Darstellung einer zweiten Ausführung der Erfindung in Form einer automatisch operierenden Projektionseinrichtung,

Fig. 7 eine Draufsicht auf das blendenähnliche Element, eine Photodetektoranordnung und schwingende Ablenkplatten von Fig. 6,

Fig. 8 ein Blockdiagramm der Steuerschaltung für die Tisch- und/oder Ausrichtmuster-Einstellmotoren von Fig. 7,

Fig. 9 eine Draufsicht auf eine Maske mit winkelartig geformten Ausrichtschlitzen, und

Fig. 10 eine Draufsicht auf ebenso winkelartig geformte Ausrichtmarken in einer Halbleiteroberfläche.

In der nachfolgenden Beschreibung mit den zugehörigen Zeichnungen sind für verschiedene Ausführungsbeispiele gleiche Teile mit derselben Bezugsziffer versehen.

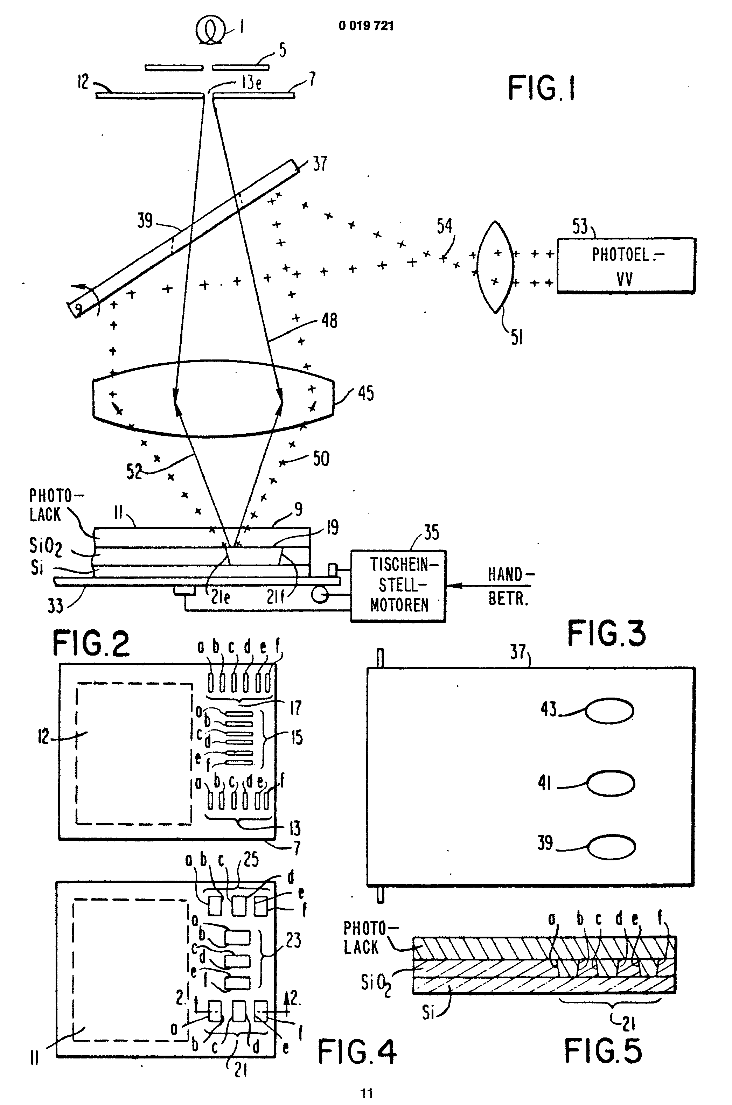

Die Fig. 1 zeigt schematisch eine optische Projektionseinrichtung gemäss der vorliegenden Erfindung. Diese Einrichtung erlaubt im besonderen das präzise Ausrichten einer Halbleiterplatte auf eine Maske, die Schaltungsmuster trägt. Die Einrichtung kann dabei für schrittweisen Betrieb mit Wiederholungen eingerichtet sein.

Wenn auch in Fig. 1 die gegenseitigen Beziehungen der Einrichtungskomponenten ersichtlich sind, so ist zu beachten, dass die Darstellung nicht massstäblich ist, um bessere Übersicht zu gewinnen. Die Lichtquelle 1, beispielsweise eine Quecksilber-Hochdruck-Bogenlampe, dient zur Beleuchtung einer Maske 7 mit Schaltungsmustern. Eine Blende 5 bewirkt, dass das Licht während des Ausrichtvorganges nur auf die Ausrichtschlitze der Maske 7 fällt. Sind Platte und Maske ausgerichtet, dann wird die Blende entfernt, so dass die Lichtquelle 1 weitere Teile der Maske beleuchten und so ein Schaltungsbild projizieren kann.

Die Blende ist bei dem Ausrichtvorgang nur dann notwendig, wenn die Photolackbeschichtung der Halbleiterplatte auf die Strahlen reagiert, welche durch die Ausrichtschlitze der Maske 7 dringen. Diese Blende kann also weggelassen werden, wenn während des Vorganges ein Filter oder ein anderes, geeignetes Mittel dazu verwendet wird, Strahlen zu erzeugen, welche die Photolackschicht nicht beeinflussen.

Bei der Herstellung von Schaltungen dient die Maske 7 mit den Mustern dazu, ein Schaltungsabbild auf die entsprechende, mit Photolack beschichtete Platte 9 zu projizieren. Diese Platte 9 besteht üblicherweise aus einer Basis z.B. aus Silizium, einer Zwischenschicht aus Siliziumoxid und einer obersten Schicht aus Photolack. Das Projektionsbild der Muster der Maske 7 belichtet Teile der photoempfindlichen Oberfläche der Platte 9. Danach werden bekannte chemische Prozesse angewendet, um auf dieser Plattenoberfläche ein Schaltungsmuster zu erzeugen, das dem Projektionsbild entspricht. Da normalerweise mehrere Herstellungsschritte zur Erzeugung eines bestimmten Schaltungsmusters auf einer Platte 9 notwendig sind, müssen Mittel gefunden werden, um die Maske 7 mit dem Schaltungsmuster präzise mit der Halbleiterplatte 9 auszurichten, bevor eine für integrierte Schaltungen vorgesehene Fläche 11 der Platte belichtet wird.

Gemäss der Fig. 2 wird in einer bevorzugten Ausführung der Erfindung eine Maske mit Schaltungsmustern verwendet, die drei getrennte Gruppen von Ausrichtschlitzen aufweisen kann. Jede dieser Gruppen wird dazu gebraucht, die Platte 9 nach bestimmten Koordinaten auf die Maske 7 auszurichten. Aus der Fig. 2 ist eine x-Koordinatengruppe 13 der Maske ersichtlich, die drei Schlitzpaare mit der Bezeichnung 13a und b; 13c und d; 13 e und f umfassen kann. Diese x-Koordinatenschlitze lassen Strahlen der Quelle 1 passieren, um Schlitzabbildungen auf der Platte 9 zu erzeugen.

In gleicher Weise kann eine y-Koordinatengruppe 15 sechs Schlitze 15a, b, c, d, e und f einschliessen. Diese dienen natürlich der Ausrichtung der Maske 7 auf die Platte 9 in Richtung der y-Koordinaten. In vielen Fällen ist ein Ausrichten nach rechtwinkligen Koordinaten x und y genügend. Es kann aber mit höherer Präzision ausgerichtet werden, wenn eine dritte Gruppe 17 von Ausrichtschlitzen für die Winkellage benutzt wird, um stets wieder nötige kleine Winkelkorrekturen in der Ausrichtung der Maske 7 auf die Platte 9 auszuführen.

Die Fig. 4 zeigt drei Gruppen von Ausrichthilfen auf einer Halbleiterscheibe, die den Schlitzen 13, 15 und 17 auf der Schaltungsmuster-Maske 7 entsprechen. Es ist ersichtlich, dass die x-Gruppe 21 von Ausrichthilfen der Platte 9 den Schlitzen 13a bis 13f der x-Koordinatengruppe der Maske 7 von Fig. 2 entspricht. Im besonderen stimmen die Schlitze 13a und 13b mit den Seitenkanten 21a und 21b der rechtwinkligen Muster auf der Platte 9 überein. Genauso passen die Schlitze 13c und 13d mit den Seitenkanten 21c und 21d und die Schlitze 13e und 13f mit den Seitenkanten 21e und 21f zusammen.

Die y-Gruppe 23 von Ausrichthilfen auf der Platte 9 besitzt ebenfalls Seitenkanten 23a–f, die mit den zugehörigen Schlitzen 15a–f der y-Koordinatengruppe 15 der Maske 7 zusammenpassen. Eine Gruppe 25 von Ausrichthilfen für die Winkellage kann ebenfalls vorgesehen werden, um Winkelkorrekturen in der Ausrichtung mit der zugehörigen Gruppe 17 von Ausrichtschlitzen der Maske 7 ausführen zu können.

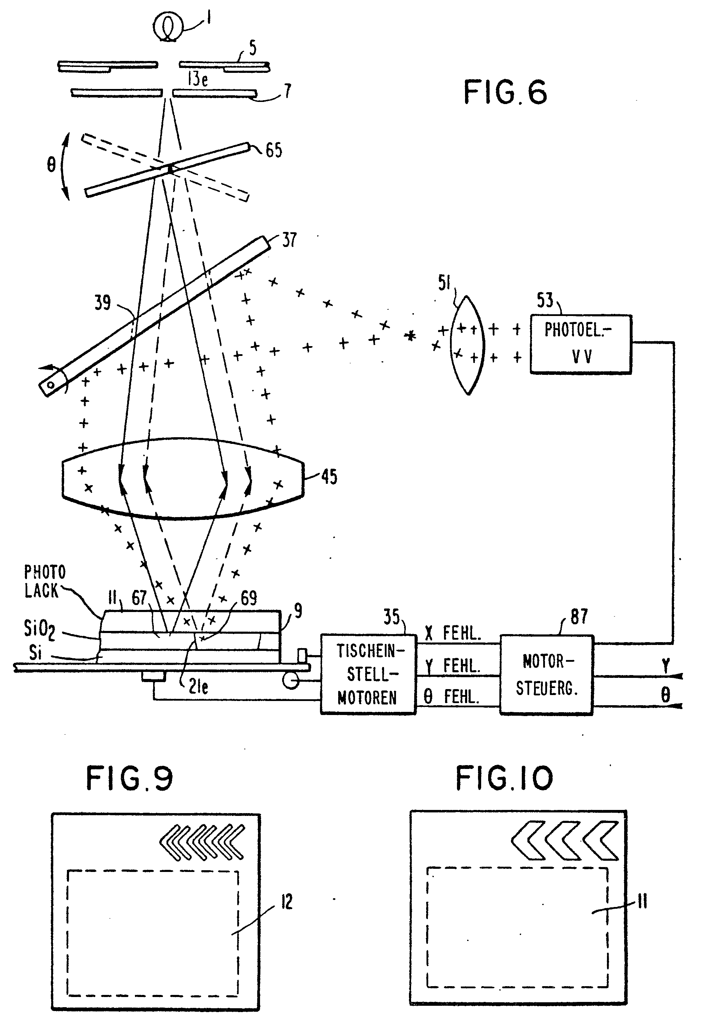

Es ist zu beachten, dass die rechtwinkligen Ausrichtmarken der Halbleiterplatte 9 als Vertiefungen in deren Oberfläche ausgebildet sind. Die Fig. 5 zeigt dies in einer Schnittansicht der Gruppe 21 von x-Ausrichthilfen, wobei der Schnitt entlang der Linie 2–2 in Fig. 4 geführt und in Pfeilrichtung gesehen ist.

Jede rechtwinklige Vertiefung besitzt entsprechende Kanten 21a bis 21f. Solche Vertiefungen der Gruppen 21, 23 und 25 können nach bekannten Verfahren hergestellt sein. Beispielsweise kann die Platte 9 zuerst zur Erzeugung von Ausrichthilfen grob auf eine Maske ausgerichtet werden, die rechtwinklige Öffnungen derselben Grösse, Form und Lage wie jene der Fig. 4 besitzt. Mit einer Lichtquelle wird dann diese Maske beleuchtet, um entsprechende rechtwinklige Abbilder auf photoempfindliche Randflächen einer Halbleiterplatte zu projizieren. Danach wird die belichtete Platte nach bekannten Verfahren behandelt und die Vertiefungen der Fig. 5 eingeätzt. Anschliessend wird

für bevorstehende Ausrichtvorgänge mit nachfolgender Belichtung durch Schaltungsmuster die Plattenoberfläche mit transparentem Photolack beschichtet. In vielen Fällen kann dieser Sondervorgang umgangen werden, wenn man die Vertiefungen während des ersten Maskierungsschrittes der Fabrikation herstellt. Es können aber auch später noch zusätzliche Vertiefungen im Laufe des Fabrikationsvorganges erzeugt werden.

Zur Vereinfachung der Darstellung ist in Fig. 1 für die Maske 7 mit den Schaltungsmustern nur ein einzelner Schlitz gezeichnet, der dem Schlitz 13e der x-Koordinatengruppe 13 von Fig. 2 entspricht. Desgleichen ist die Platte 9 nur mit einer einzelnen, zugehörigen Vertiefung 19 als Ausrichtmarke abgebildet, die zwei Kanten 21e und 21f besitzt. Um die Einzelheiten der Erfindung besser darzulegen, sind die Platte 9 mit der Vertiefung 19 und die Maske 7 mit dem Schlitz 13e der x-Koordinatengruppe in Fig. 1 im Vergleich zu den anderen Komponenten der Einrichtung stark vergrössert gezeichnet.

Bei einer bevorzugten Ausführung der Erfindung messen in der Plattenebene die Ausrichtschlitze der Maske 7 etwa 2 µm in der Breite, 20 µm in der Länge und liegen zwischen 6 und 10 µm weit voneinander weg.

Eine Halbleiterplatte 9 mit Vertiefungen 19 als Ausrichthilfen gemäss den Fig. 4 und 5 liegt während der Arbeitsvorgänge auf einem Ausrichttisch 33, der in bekannter Art ausgeführt sein kann. Ein solcher ist beispielsweise im US-Patent 3 870 416 beschrieben. Solche Tische dienen dazu, die Halbleiterplatte über kleinste Strecken in der x- und y-Richtung zu verschieben oder um kleinste Winkel zu schwenken. Obwohl die erfinderische Einrichtung nicht auf die Verwendung eines bestimmten Ausrichttisches beschränkt ist, so ist doch für das Erzielen höchster Genauigkeit in einer bevorzugten Ausführung der Einsatz eines Tisches empfehlenswert, dessen Bewegungssteuerung mit einem Laser-Interferometer ausgerüstet ist. Ein geeigneter Antrieb 35 für den Ausrichttisch dient der Verschiebung in x- und y-Richtung und der Drehung um einen Winkel soweit notwendig. Das Ausrichten kann aber auch durch Verschiebung und Rotation der Maske 7 geschehen.

Wenn eine Platte 9 auf den Tisch 33 gelegt und eine passende Maske 7 mit Schaltungsmustern und Ausrichtschlitzen gemäss Fig. 2 eingesetzt worden ist, werden Maske und Platte vorerst grob ausgerichtet. Danach wird die Blende 5 geöffnet, um die Maske mit Strahlen der Quelle 1 zu beleuchten, wodurch auch Licht durch die Ausrichtschlitze der x-, y- und Winkel-Koordinatengruppe 13 bis 17 fällt. Die durchgelassenen Strahlen beleuchten die opake obere Fläche eines blendenähnlichen Elementes 37, beispielsweise eines gewöhnlichen, ebenen Spiegels, der schwenkbar angeordnet ist und in die optische Achse der Einrichtung gebracht werden kann, wenn ausgerichtet wird, und der wieder hinausgeschwenkt wird, wenn das Ausrichten beendet ist. Die Strahlen der x-, y- und Winkel-Koordinatengruppe 13 bis 17 fallen dabei durch entsprechende Öffnungen im Element 37, die beispielsweise elliptische Form haben.

Die Fig. 3 zeigt eine Draufsicht des blendenähnlichen Elementes 37. Eine untere Öffnung 39 liegt so, dass die durch die Schlitze 13a–f in der Maske 7 fallenden Strahlen von ihr durchgelassen werden. Desgleichen lässt eine mittlere Öffnung 41 die Strahlen der Schlitze 15a–f und eine obere Öffnung 43 die von den Schlitzen 17a–f stammenden Strahlen durch.

Die Strahlen, welche durch die elliptischen Öffnungen des Blendenelementes 37 fallen, gelangen auf eine Teilfläche der Eingangsöffnung einer telezentrischen Projektionslinse 45. Die Abmessungen der Öffnungen 39, 41 und 43 und die Lage des Blendenelementes 37 sind so gewählt, dass nur etwa die Hälfte der vollen Apertur der Eingangspupille der Projektionslinse 45 Strahlen empfängt, die durch die Öffnungen 39, 41 und 43 fallen. Diese Lage sowie die Öffnungsabmessungen des Blendenelementes 37 können aber auch verändert werden, um einen grösseren oder kleineren Teil der Öffnung der Linse 45 für den Ausricht-Strahlengang zu benutzen. Ausserdem kann nach dem Babinet-Prinzip eine äquivalente Anordnung benutzt werden, wobei die bisherigen Spiegelflächen des Blendenelementes 37 transparent und die elliptischen Öffnungen durch Spiegel ersetzt wären.

Die durch den Schlitz 13e und die Öffnung 39 fallenden Strahlen 48 werden von der telezentrischen Projektionslinse 45 in einem Bereich fokussiert, der der Kante 21e der Vertiefung 19 entspricht. Die Ausdehnung in der Breite ist etwa gleich der Lichtwellenlänge geteilt durch die numerische Apertur des beleuchtenden Strahlenbündels. Wie die Fig. 1 zeigt, wird ein Teil 50 dieser Strahlen an der Kante 21e ungerichtet reflektiert und dringt anschliessend durch die äusseren Teile der telezentrischen Linse 45 oder des Objektivs. Die reflektierten Strahlen werden von den reflektierenden Flächen des Blendenelementes 37 ausgelenkt und von der Linse 45 im Bereich 54 gesammelt. Eine Vorrichtung zur Messung der Strahlenintensität, z.B. eine Sammellinse 51 mit nachfolgendem photoelektrischem Vervielfacher 53, empfängt die reflektierten Strahlen und erzeugt ein der Intensität proportionales Signal. Ein anderer Teil 52 der Strahlen 48 wird durch die Öffnung 39 zurückgeworfen.

Die vom Photovervielfacher 53 registrierte Strahlenintensität entspricht der an der Kante der Vertiefung 19 in der Platte 9 reflektierten Strahlenmenge. Die Erfindung ist natürlich nicht auf diese Vorrichtung zur Strahlenintensitätsmessung beschränkt.

Wenn also der Ausrichttisch 33 in einem kleinen Bereich in der x-Koordinatenrichtung verschoben wird, dann wird der Photovervielfacher 53 ein Strahlenmaximum messen, das der Ausrichtung des Schlitzes 13e der Maske 7 auf die entsprechende Kante 21e der Vertiefung 19 in der Platte 9 entspricht. Ein Maximum der reflektierten Strahlen bedeutet also Ausrichtung der Maske 7 auf die Platte 9. In der Praxis ist es unvermeidlich, dass kleine Schrägungen der Ausrichtkanten und kleine Versetzungsfehler verursacht durch Über- oder Unterätzen vorkommen. Es ist daher empfehlenswert, Paare von Ausrichtschlitzen in der Maske zur gegenseitigen Kompensation zu verwenden. Mehrere solcher Schlitzpaare können auch zur Verbesserung der Messempfindlichkeit benutzt werden.

Der Einsatz der Einrichtung gemäss Fig. 1 ist bisher nur bezüglich eines einzelnen Schlitzes und der zugehörigen Vertiefung 19 in der x-Koordinatenrichtung beschrieben worden. Im wirklichen Betrieb werden aber gleichzeitig alle Schlitze der x-Koordinatengruppe 13 in der Maske 7 gegenüber den Kanten der rechtwinkligen Vertiefungen der Gruppe 21 von Ausrichthilfen verschoben. Desgleichen werden auch die Schlitze der y-Koordinatengruppe 15 in der Maske 7 gegenüber den zugehörigen Kanten der rechtwinkligen Vertiefungen der Gruppe 23 von y-Ausrichthilfen in der Platte 9 verschoben. Ist zudem eine Winkeljustierung vorgesehen, dann wird auch die Winkellage des Ausrichttisches 33 verändert, um die Ausrichtschlitze der Gruppe 17 für die Winkellage in der Maske 7 mit den zugehörigen Kanten der rechtwinkligen Ausrichtmarken in der Gruppe 25 auf der Platte 9 in Übereinstimmung zu bringen.

Die Öffnungen im Blendenelement 37 brauchen natürlich nicht elliptisch zu sein, um die Strahlen der Ausrichtschlitze durchzulassen. Abhängig von der Lage dieses Elementes sowie von der Form der Ausrichthilfen können ebensogut anders, z.B. rechteckig geformte Öffnungen benutzt werden. Im weiteren kann die Photolackschicht, welche die Ausrichtvertiefungen bedeckt, ganz oder teilweise entfernt werden, um die Messung der von den Ausrichtkanten abgelenkten Strahlung zu erleichtern.

Gemäss Fig. 1 wird der Ausrichttisch 33 mit der Halbleiterplatte 9 verschoben, damit die Abbilder der Ausrichtschlitze mit den Ausrichthilfen auf der Platte zur Deckung gebracht werden können. In der Regel ist wenigstens eine ganze Hin- und Herbewegung nötig, um die Maske 7 und die Platte 9 auszurichten. Da diese Abtastung durch mechanische Bewegung ausgeführt wird, dauert sie üblicherweise einige Zehntelsekunden. Diese Abtastbewegung mag für gewisse Anwendungen zufriedenstellend sein, ist jedoch für rationelle Herstellungsanlagen ungeeignet. Daher ist in Fig. 6 eine andere, bevorzugte Ausführung der Erfindung dargestellt, in welcher durch eine optische Abtastbewegung rasch und automatisch die Abbildungen der Ausrichtschlitze mit den zugehörigen Ausrichtkanten in der Platte 9 zur Deckung gebracht werden, um Maske und Platte miteinander auszurichten.

In der Fig. 6 ist eine transparente Ablenkplatte 65, die aus Glas bestehen kann, zwischen der Maske 7 mit den Schaltungsmustern und dem Blendenelement 37 eingezeichnet. Sie ist um eine Achse drehbar angeordnet, die senkrecht zur optischen Projektionsachse der Einrichtung und parallel zur Ebene der Maske 7 liegt. Im Betrieb führt die Ablenkplatte 65 eine schwingende Bewegung mit dem Auslenkwinkel 0 aus, um die durch einen Schlitz, wie 13e, der Maske 7 fallenden Strahlen abzulenken. Bei einer bestimmten Lage der Ablenkplatte 65 fällt die Abbildung des Schlitzes 13e auf die Stelle 67 der Photolackschicht auf der Platte 9 oder direkt auf die Platte, falls die Photolackschicht ganz oder teilweise über den Ausrichthilfen entfernt worden ist. Schwenkt nun die Ablenkplatte 65 mit einem gewissen Winkel um ihre Achse, so verschiebt sich die Abbildung des Schlitzes 13e um eine gewisse Strecke über der stillstehenden Platte 9 zu einer benachbarten Position 69.

Wenn mit den durch den Schlitz 13e hindurchtretenden Strahlen die Fläche der Platte 9 in der Nähe der Kante 21e abgetastet wird, werden an der Oberfläche der Platte 9 wechselnde Mengen direkt reflektierter bzw. abgelenkter Strahlen erzeugt. Das projizierte Bild des Schlitzes 13e tastet also optisch die Plattenoberfläche 9 in der Nähe der Kante 21e ab, indem die Ablenkplatte 65 eine Winkelbewegung ausführt, und der Photovervielfacher 53 empfängt Strahlen wechselnder Intensität.

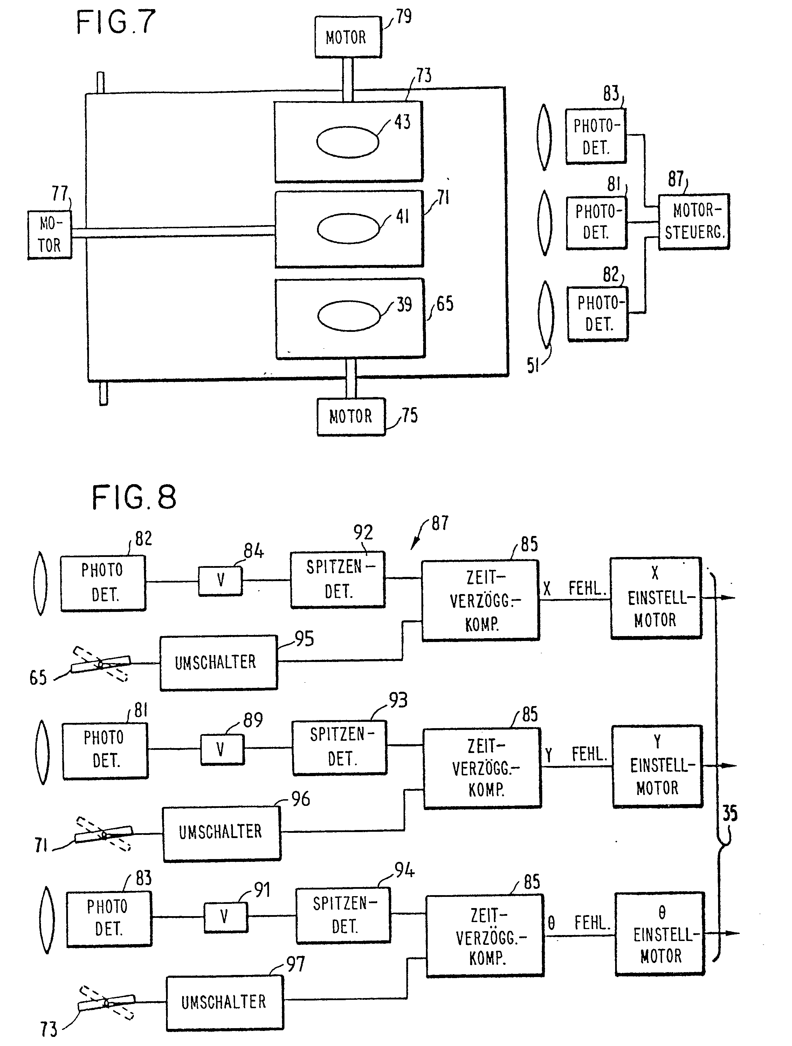

Im Interesse der Klarheit der Fig. 6 ist dort nur eine einzelne Ablenkplatte 65 und ein einzelner Schlitz 13e eingezeichnet. Durch die Schwenkungen der Ablenkplatte 65 tasten die Abbildungen aller Schlitze 13a–13f der x-Koordinatengruppe 13 in der Maske 7 die zugehörigen Kanten 21a–21f der rechteckigen Vertiefungen der x-Gruppe 21 der Ausrichthilfen auf der Platte 9 ab. Zusätzlich ist gemäss Fig. 7 eine weitere schwenkbare Platte 71 vorgesehen, um mittels der Schlitzabbilder der y-Koordinatengruppe 15 der Maske die y-Ausrichthilfen auf der Platte 9 abzutasten. Eine dritte Ablenkplatte 73 kann hinzugefügt werden, um mit den Schlitzabbildern der Winkelausrichtgruppe der Maske die entsprechenden Winkelausrichthilfen der Platte 9 abzutasten.

Jede dieser Ablenkplatten 65, 71 und 73 wird durch einen entsprechenden Motor 75, 77 bzw. 79 in schwingende Bewegung versetzt. Experimentell ist die Dicke der Ablenkplatten mit etwa 1 mm bestimmt worden, was eine brauchbare Ablenkung der Strahlen ergibt, ohne die Fokussierung in den Maskenabbildungen auf der Halbleiterplatte zu stören. Diese Dicke gilt für ein telezentrisches Objektiv mit einer Apertur von annähernd 0,3 und einer fünffachen Verkleinerung.

Schwenkplatten-Abtastgeräte mit schwingenden, transparenten Platten zur Ablenkung von Strahlen sind bekannt und käuflich erwerbbar. So ist beispielsweise ein «Leitz»-Kantenabtastdetektor bekannt, der nach diesem Verfahren mittels Ablenkung eines Lichtstrahls eine Kante abtastet und deren Vorhandensein feststellt.

Zur Justierung wird die Maske 7 mit der Platte 9 anfänglich grob ausgerichtet, und danach werden mit den Ausrichtmarken nach x-Koordinaten optisch die zugehörigen Kanten auf der Platte 9 abgetastet. Währenddessen stellt der Photodetektor 82 ein Maximum reflektierter Strahlen fest, wenn jede Schlitzabbildung mit der zugehörigen Ausrichtkante übereinstimmt. Aus der Fig. 7 ist ersichtlich, dass der Photodetektor 81 ebenfalls ein Strahlenmaximum ermittelt, wenn die Projektionsbilder der Schlitze 15a–15f auf die zugehörigen Kanten 23a–23f fallen. Dasselbe gilt für den Photodetektor 83 bei Ausrichtung der Schlitze 17a–17f auf die Kanten 25a–25f.

Die von den Photodetektoren 81, 82 und 83 erzeugten Spannungssignale werden in der Motorsteuerschaltung 87 der Fig. 8 an entsprechende Verstärker 84, 89, 91 und eine Spitzendetektoren 92, 93, 94 aufweisende Auswertschaltung weitergeleitet. Anschliessend wird ein Registerpunkt für die von jedem Detektor gemessene Spitzenspannung festgelegt. Dieser entspricht der Winkellage einer Ablenkplatte, bei welcher der zugehörige Detektor 81, 82, 83 ein Spannungsmaximum feststellt. Da jede Ablenkplatte 65, 71, 73 hin und her schwingt, kann die Messspannung bezogen auf den Stellungswinkel der betreffenden Platte aufgezeichnet werden. Dies ergibt eine Spannungskurve mit einem Maximum bei einer bestimmten Winkelstellung, welche dem Registerpunkt entspricht.

Ist der Störungsanteil der Detektorspannung relativ hoch, kann eine Schmitt-Triggerschaltung benutzt werden, um bei einem vorgegebenen Schwellenwert an der vorderen sowie an der hinteren Flanke der Spannungskurve je einen Registerimpuls abzugeben. Der Zeitpunkt, an dem jeder Registerimpuls erzeugt wird, entspricht einer besonderen Winkellage der Ablenkplatte. Die so definierten zwei Winkellagen schliessen eine besondere Winkellage ein, bei der die Detektorspannung ein Maximum erreicht und dem Registerpunkt entspricht.

Für jede schwingende Ablenkplatte 65, 71, 73 erzeugt ein zugehöriger, als Umschalter 95, 96, 97 ausgelegter Geber einen Referenzimpuls, und zwar wenn die Ablenkplatte sich in einer bestimmten Lage befindet. Dies kann beispielsweise die Lage sein, in der die Abbildung nicht verschoben wird. Die Registerimpulse geben also die Winkelstellung der Ablenkplatte bei bestimmten Schwellenspannungen an, die das theoretische Spannungsmaximum am Registerpunkt einschliessen. Der Referenzimpuls hingegen bezeichnet den Zeitpunkt, bei welchem die Ablenkplatte so steht, dass keine Bildverschiebung verursacht wird. Es ergibt sich somit, dass die Zeitverzögerung von der Mitte zwischen beiden Registerimpulsen zum Referenzimpuls proportional dem Ausrichtfehler der Halbleiterplatte 9 mit Bezug auf die Maske 7 mit den Schaltungsmustern ist. Wird die Lage der Halbleiterplatte bezüglich der Maske in Richtung einer Verminderung dieser Zeitverzögerung verändert, dann wird auch die Ausrichtung von Maske und Platte verbessert.

Statt der Umschalter 95, 96, 97 können auch andere Mittel zur Erzeugung eines Referenzimpulses eingesetzt werden, wenn die zugehörige Ablenkplatte sich in einer besonderen Winkellage befindet. Beispielsweise kann eine periodische Sägezahnspannung dazu verwendet werden, die Antriebsmotore 75, 77, 79 zu speisen, die die Ablenkplatten 65, 71, 73 in Schwingungen versetzen. Diese Sägezahnspannung definiert dann jederzeit die Winkellage der betreffenden schwingenden Ablenkplatte. Die Sägezahnspannung kann daher einem Schmitt-Trigger zur Erzeugung des Referenzimpulses zugeführt werden.

Die Zeitverzögerungskomparatoren 85 vergleichen den Mittelpunkt zwischen den Registerimpulsen, der dem Maximum entspricht, mit dem Referenzimpuls für jede Ablenkplatte und erzeugen dementsprechend ein Ausrichtfehlersignal. Dieses letztere wird als Analogspannung über einen nachgeschalteten Antriebsverstärker den Einstellmotoren 35 des Ausrichttisches 33 eingegeben, der gesteuert durch ein Laser-Interferometer und abhängig von Vorzeichen und Grösse des Fehlersignals in eine bestimmte Koordinaten-Richtung verschoben wird. Natürlich wird gemäss dem beschriebenen Verfahren ein Fehlersignal für jede Koordinaten-Richtung erzeugt, um den Ausrichttisch 33 in die Ausrichtlage zu verschieben. Die Fehlersignalerzeugung sowie die Tischverschiebung in entsprechende Koordinaten-Richtungen geschieht solange, bis die Zeitverzögerung in jeder Richtung null oder fast null ist.

Höhere Präzision bei der Bestimmung des Registerpunktes oder des Spannungsmaximums kann durch zusätzliche Schmitt-Triggerschaltungen erreicht werden, wenn diese auf verschiedene Schwellenspannungswerte ansprechen. Beispielsweise können zwei Schmitt-Trigger vorgesehen werden, die nach obigem Verfahren vier Registerimpulse für vier entsprechende Winkelstellungen erzeugen. Diese Registerimpulse und der Referenzimpuls erlauben dann die Bestimmung der zugehörigen mittleren Verzögerungszeit.

Wenn der Störungsanteil der Detektorspannung eher klein ist, kann die Bestimmung des Registerpunktes oder des Spannungsmaximums dadurch erfolgen, dass die Grösse der Detektorspannung, welche für verschiedene Winkellagen der Ablenkplatte gemessen wird, in digitaler Form gespeichert wird. Danach kann mit bekannten Kurvenanpassungsverfahren die Intensitätskurve mit der höchsten Wahrscheinlichkeit als Funktion der Winkellage definiert werden. Der Nulldurchgang der ersten Ableitung der Kurve bezogen auf die Winkellage kann anschliessend zur Bestimmung des Maximums der Spannungskurve und des entsprechenden Registerpunktes herangezogen werden. Die zwischen Registerpunkt und Referenzimpuls liegende Zeitverzögerung wird wie bereits beschrieben zur Einstellung des Ausrichttisches ausgenutzt.

Obwohl das Ausrichten nach x-, y- und Winkelkoordinaten in Kombination beschrieben worden ist, kann die Einrichtung sehr wohl für das Ausrichten von Maske und Platte in bloss einer, oder zwei, oder mehr Richtungen ausgeführt werden. Denkbar ist beispielsweise eine Einrichtung zum Ausrichten einer Maske mit Schaltungsmustern auf eine Halbleiterplatte in Richtung der x- und y-Koordinaten allein, wobei die Winkellage durch andere Mittel justiert wird.

Die bisher beschriebenen und abgebildeten Ausrichtschlitze hatten Balkenform und die zuge-

11 | 0 019 721 | 12

hörigen Vertiefungen als Ausrichthilfen waren daher rechteckig. Es können jedoch auch andere Formen benutzt werden. In den Fig. 9 und 10 sind beispielsweise winkelförmige Schlitze für die Maske 7 vorgesehen, und ebensolche winklig geformte Vertiefungen mit ensprechenden Kanten können in der Halbleiterplatte 9 gebildet werden. Die beschriebene Einrichtung würde bei Verwendung dieser Form von Ausrichtmarken zusätzliche Verarbeitungsschaltungen benötigen, um ein Ausrichten nach x- und y-Koordinaten durchzuführen. Solche Schaltungen sind daher für den Fachmann nur eine Frage der Projektierung; sie stellen kein prinzipiell neues Problem dar. Zudem ist zu berücksichtigen, dass jedes Mittel zur Erzeugung einer Relativbewegung zwischen den Abbildungen einer Schaltungsmustermarke 7 und einer Halbleiterplatte 9 brauchbar ist, obwohl hier Ausführungen beschrieben worden sind, welche die Schlitzabbilder oder die Platte als Abbildungsebene bewegen, um so mittels der Abbildungen die Platte abzutasten. Es könnte daher z.B. die Maske 7 zur Ausübung der Abtastfunktion bewegt werden.

**Patentansprüche**

1. Optische Projektionseinrichtung zum Ausrichten eines Projektionsbildes auf einer Oberfläche (9), in der sich wenigstens eine Ausrichtmarke (19) befindet, mit einer Strahlungsquelle (1), einer den Strahlengang unterbrechenden, aber wenigstens für einen zum Ausrichten genügenden Strahlungsanteil (48) durchlässigen Maske (7), ferner mit einem Objektiv (45), das die Maske (7) auf die Oberfläche (9) abbildet und die von der Oberfläche (9) reflektierten Strahlen in Richtung eines Strahlendetektors (53) fokussiert, mit einem teildurchlässigen Spiegel (37) zur Trennung von Projektions- und Beobachtungsstrahlengang, und mit Vorrichtungen (33, 35, 65, 87) zum Ausführen einer Relativbewegung zwischen Projektionsbild und Ausrichtmarke (19) unter Überwachung der Intensität der reflektierten Strahlen (50) zwecks Ausrichtung der genannten Oberfläche (9) mit der Maske (7) in einer durch ein Maximum der reflektierten Strahlen definierten Lage, dadurch gekennzeichnet, dass der teildurchlässige Spiegel (37) als geometrischer Strahlenteiler ausgebildet ist, der den zum Ausrichten vorgesehenen Strahlenanteil (48) zu der auszurichtenden Oberfläche (9) durchlässt und den an der oder den Ausrichtmarken (19) reflektierten Strahlungsanteil (50) zum Strahlungsdetektor (53) ablenkt.

2. Einrichtung nach Anspruch 1, dadurch gekennzeichnet, dass der Spiegel (37) in feststehender Lage zwischen Maske (7) und Objektiv (45) um eine Achse schwenkbar angeordnet ist, und dass er auf der dem Objektiv (45) zugewandten Seite als Spiegelfläche ausgebildet ist.

3. Einrichtung nach Anspruch 1, dadurch gekennzeichnet, dass das Objektiv (45) telezentrisch ausgebildet ist.

4. Einrichtung nach Anspruch 1, dadurch gekennzeichnet, dass die Öffnung (39) oder die Öffnungen (39, 41, 43) im Spiegel (37) im wesentlichen elliptisch geformt sind, und dass die Lage des Spiegels und dessen Öffnungsgrösse derart gewählt sind, dass die hindurchfallenden Strahlen (48) die Hälfte der Objektiv-Apertur beleuchten.

5. Einrichtung nach Anspruch 1, dadurch gekennzeichnet, dass die genannte Maske (7) Schlitzpaare (13a/b, c/d, e/f) aufweist, die in wenigstens einer Gruppe (13) einer Koordinatenrichtung zugehörig angeordnet und auf der genannten Oberfläche (9) abgebildet sind, und dass die Oberfläche den Schlitzpaaren der Maske entsprechende Ausrichtmarken (21) aufweist, die Ausrichtkantenpaare (21a/b, c/d, e/f) besitzen und in wenigstens einer Gruppe (21) derselben Koordinatenrichtung zugehörig angeordnet sind.

6. Einrichtung nach Anspruch 1, dadurch gekennzeichnet, dass die Vorrichtungen zur Ausführung einer Relativbewegung wenigstens ein Strahlenablenkelement (65) umfassen, das einer Koordinatenrichtung zugeordnet und so ausgebildet ist, dass mit dem genannten Strahlenanteil (48) die in der Oberfläche (9) befindliche Ausrichtmarke (9) abtastbar ist.

7. Einrichtung nach Anspruch 6, dadurch gekennzeichnet, dass das genannte Strahlenablenkelement als transparente Ablenkplatte (65) zwischen der Maske (7) und dem Spiegel (37) angeordnet und um eine der Maskenebene parallele Achse hin und her schwingbar ausgebildet ist, so dass die Strahlablenkung eine Funktion der Winkellage der Ablenkplatte (65) ist.

8. Einrichtung nach Anspruch 7, dadurch gekennzeichnet, dass die Vorrichtungen zum Ausführen einer Relativbewegung wenigstens einen Referenzimpulsgeber (95, 96, 97) umfassen, dessen Impuls die Winkellage einer Ablenkplatte (65) definiert, wenn der genannte Strahlenanteil (48) nicht abgelenkt ist, dass ferner wenigstens ein Strahlendetektor (53, 81, 82, 83) mit Auswerteschaltungen (92, 93, 94) zur Abgabe eines dem Maximum der reflektierten Strahlen entsprechenden Registerimpulses ausgerüstet ist, und dass schliesslich eine Motor-Steuerschaltung (87) vorgesehen und derart ausgelegt ist, dass die genannte Oberfläche (9) mit Bezug auf die Maske (7) durch eine Einstellvorrichtung (35) in wenigstens einer Koordinatenrichtung proportional zur Zeitverzögerung zwischen Referenzimpuls und Registerimpuls verschiebbar ist. (Fig. 7, 8).

**Claims**

1. Optical projection apparatus for aligning a projected image on a surface (9), the surface (9) having at least one alignment aid (19), with a radiation source (1), a mask (7) for interrupting the said radiation but passing at least a portion (48) of the radiation sufficient for the alignment, further with an objective (45) projecting the mask (7) onto the surface (9) and focusing the radiation reflected from the surface (9) in the direction of a photodetector (53), with a partially transparent mirror (37) for separating the projection and imaging radiations, and with means (33, 35, 65, 87) for performing a relative movement between projected image and alignment aid (19) while monitoring the intensity of the reflected radiation (50) for aligning said surface (9) with the mask (7) in a position defined by the maximum of the reflected radiation, characterized in that the partially transparent mirror (37) is designed as a geometrical beam splitter which passes that portion (48) of the radiation which is intended for alignment through to the surface (9) to be aligned and which deflects that portion (50) of the radiation reflected from the alignment aid(s) (19).

2. Apparatus according to claim 1, characterized in that the mirror (37) is arranged pivotable about an axis in a rigid position between the mask (7) and the objective (45), and that it is made to be a reflective mirror on the side facing the objective (45).

3. Apparatus according to claim 1, characterized in that the objective (45) is telecentric.

4. Apparatus according to claim 1, characterized in that the opening (39) or the openings (39, 41, 43) in the mirror (37) have an essentially elliptical form, and that the position of the mirror as well as the size of its openings are chosen such that the passing radiation (48) illuminates half of the aperture of the objective.

5. Apparatus according to claim 1, characterized in that said mask (7) has pairs of slits (13a/b, c/d, e/f) which are arranged in at least one group (13) associated with one direction of the coordinate system and which are projected on said surface (9), and that the surface (9) has alignment aids corresponding to the pairs of slits of said mask, the alignment aids having pairs of alignment edges (21a/b, c/d, e/f) and are arranged in at least one group associated with the same direction of the coordinate system.

6. Apparatus according to claim 1, characterized in that the means for performing a relative movement comprise at least one beam deflector element (65) associated with one direction of the coordinate system and so designed that by means of said portion (48) of the radiation the alignment aid (19) on said surface (9) can be detected.

7. Apparatus according to claim 6, characterized in that said beam deflector element is a transparent deflector plate (65) arranged between the mask (7) and the mirror (37) and pivotable about an axis parallel to the plane of the mask, such that the deflection of the radiation is a function of the angular position of the deflector plate (65).

8. Apparatus according to claim 7, characterized in that the means for performing a relative movement comprise at least one reference pulse generator (95, 96, 97) the output pulse of which defines the angular position of a deflector plate (65) whenever the said portion (48) of the radiation is not deflected, that further at least one radiation detector (53, 81, 82, 83) is equiped with circuitry (92, 93, 94) for providing a register pulse corresponding to the maximum of the reflected radiation, and that finally a motor control circuit (87) is provided and designed such that said surface (9) is shiftable with respect to the mask in at least one direction of the coordinate system in proportionality with the time delay between reference pulse and register pulse (fig. 7, 8).

## Revendications

1. Appareil de projection optique pour l'alignement d'une image de projection sur une surface (9), sur laquelle se trouve au moins un dispositif de repère d'alignement (19), comportant une source de radiations (1), un masque (7) qui stoppe les radiations à l'exception d'une fraction des rayons (48) destinés à l'alignement, ainsi qu'un objectif (45) qui reproduit l'image du masque (7) sur la surface (9) et qui focalise les rayons réfléchis par ladite surface (9) vers un détecteur de rayons (53), et comportant également un miroir semi-transparent (37) qui sépare le faisceau des rayons de projection et celui des rayons d'analyse et des dispositifs (33, 35, 65, 87) qui réalisent un mouvement relatif entre l'image de projection et le dispositif de repère d'alignement (19) tout en contrôlant l'intensité des rayons réfléchis (50) afin d'aligner ladite surface (9) avec ledit masque (7) dans une position définie par un maximum de rayons réfléchis, caractérisé en ce que ledit miroir (37) semi-transparent est réalisé comme diviseur de rayons géométriques, lequel est transparent aux faisceaux de rayons (48) prévus pour l'alignement de ladite surface à aligner (9) et dévie vers le détecteur de rayonnement (53) le faisceau des rayons (50) réfléchis par le ou les dispositif de repères d'alignement (19).

2. Appareil selon la revendication 1, caractérisé en ce que ledit miroir (37), pivotant sur un axe, est monté dans une position fixe entre ledit masque (7) et ledit objectif (45), et en ce qu'il est réalisé comme surface de réflexion sur son côté faisant face audit objectif (45).

3. Appareil selon la revendication 1, caractérisé en ce que ledit objectif (45) télécentrique.

4. Appareil selon la revendication 1, caractérisé en ce que l'ouverture (39) ou les ouvertures (39, 41, 43) prévues dans le miroir (37) ont, pour l'essentiel, une forme elliptique, et en ce que le positionnement dudit miroir et les dimensions desdites ouvertures sont choisies de sorte que les rayons (48) admis à travers ces ouvertures illuminent la moitié de l'ouverture de l'objectif.

5. Appareil selon la revendication 1, caractérisé en ce que ledit masque (7) comporte des paires de fentes (13a/b, c/d, e/f) qui sont disposées dans au moins dans un groupe (13), lui-même disposé selon une direction du système de coordonnées, et qui sont reproduites sur ladite surface (9) et en ce que ladite surface comporte des dispositifs de repère d'alignement (21) correspondant auxdites paires de fentes du masque, ces dispositifs de repère d'alignement étant des paires d'arrêtes d'alignement (21a/b, c/d, e/f) réunies dans au moins un ensemble disposé selon la même direction du système de coordonnées.

6. Appareil selon la revendication 1, caractérisé en ce que les dispositifs prévus pour exécuter le mouvement relatif comprennent au moins un élément de déflexion (65) qui est disposé selon une direction du système de coordonnées et qui est réalisé de telle sorte que ledit dispositif de repère d'alignement disposé sur ladite surface peut être détecté au moyen d'une fraction desdits rayons (48).

7. Appareil selon la revendication 6, caractérisé en ce que ledit élément de déflexion est une plaque déviatrice transparente (65) qui est située entre ledit masque (7) et ledit miroir (37) et, qui est montée de façon à pouvoir pivoter autour d'un axe parallèle à ladite surface du masque de sorte que la déviation des rayons dépend de la position angulaire de ladite plaque déviatrice (65).

8. Dispositif selon la revendication 7, caractérisé en ce que les dispositifs prévus pour exécuter ledit mouvement relatif comprennent au moins un générateur d'impulsions de référence (95, 96, 97) dont l'impulsion émise quand ladite fraction des rayons (48) n'est pas déviée, définit la position angulaire d'une plaque déviatrice (65), en ce qu'au moins un détecteur de rayons (53, 81, 82, 83) comporte des circuits (92, 93, 94) qui délivrent une impulsion d'analyse correspondant au maximum des rayons réfléchis, et enfin, en ce qu'il est prévu un circuit de commande de moteur (87) conçu de telle sorte que, par l'intermédiaire d'un dispositif de réglage (35), ladite surface (9) puisse être décalée par rapport au masque (7), dans au moins une direction du système de coordonnées, et ce, de façon proportionnelle au retard de l'impulsion de référence par rapport à l'impulsion d'analyse (figures 7, 8).

0 019 721

FIG.1

FIG.2

FIG.3

FIG.4

FIG.5

# FIG.6

PHOTOEL.-
V V

PHOTO
LACK

SiO2

Si

TISCHEIN-
STELL-
MOTOREN

X FEHL.

Y FEHL.

θ FEHL.

MOTOR-
STEUERG.

Y

θ

# FIG.9

# FIG.10

# FIG.7

# FIG.8